# FASCICULE DE BREVET EUROPEEN

(11) **EP 1 627 422 B1**
(45) Date de publication et mention de la délivrance du brevet: **15.08.2012**
(21) Numéro de dépôt: 04715928.0
(22) Date de dépôt: 01.03.2004
(51) Int. Cl.: H01L 21/28, H01L 21/321, H01L 21/316

(54) **PROCEDE DE DELIMITATION D'UN ELEMENT CONDUCTEUR DISPOSE SUR UNE COUCHE ISOLANTE**
VERFAHREN ZUR HERSTELLUNG EINES LEITENDEN ELEMENTES AUF EINER ISOLIERSCHICHT
METHOD OF DELINEATING A CONDUCTING ELEMENT WHICH IS DISPOSED ON AN INSULATING LAYER

(30) Priorité: 05.03.2003 FR 0302721
(43) Date de publication de la demande: 22.02.2006
(73) Titulaire: Commissariat à l'Énergie Atomique et aux Énergies Alternatives, 75015 Paris (FR)
(72) Inventeur: DELEONIBUS, Simon, F-38640 Claix (FR)
(74) Mandataire: Hecké, Gérard
(86) Numéro de dépôt international: PCT/FR2004/000467
(87) Numéro de publication internationale: WO 2004/082004

(56) Documents cités:
- US-A1- 2001 020 723
- US-B1- 6 331 490
- US-B1- 6 451 657
- PATENT ABSTRACTS OF JAPAN vol. 2002, no. 09, 4 septembre 2002 (2002-09-04) & JP 2002 134544 A (ROHM CO LTD), 10 mai 2002 (2002-05-10)

## Description

### Domaine technique de l'invention

L'invention concerne un procédé de délimitation d'un élément conducteur disposé sur une couche isolante, comportant le dépôt d'une couche conductrice sur la face avant de la couche isolante disposée sur un substrat, la formation d'un masque sur au moins une zone de la couche conductrice destinée à former l'élément conducteur, de manière à délimiter dans la couche conductrice au moins une zone complémentaire non-recouverte par le masque, les zones complémentaires de la couche conductrice étant rendues isolantes par oxydation.

### État de la technique

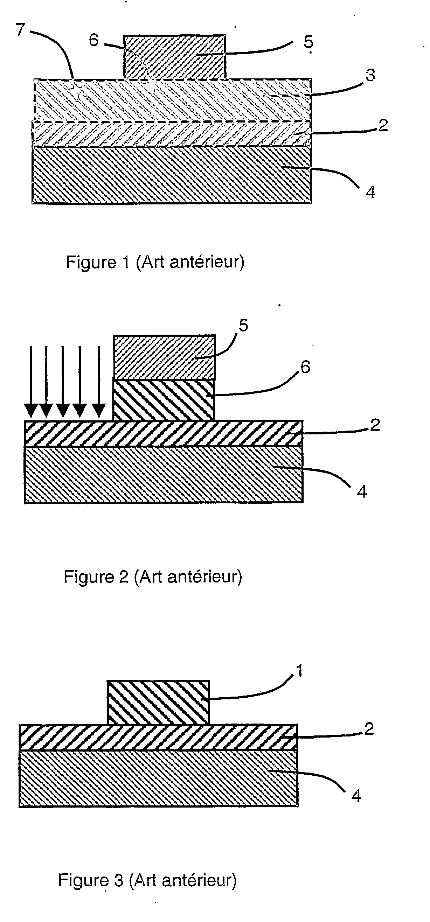

Les dispositifs micro-électroniques comportent souvent des éléments conducteurs 1 (figure 3) séparés d'un substrat 4 par une couche isolante 2 très fine. Par exemple, la grille des transistors de type MOS (« metal oxide semiconductor : MOS ») de différentes natures, en particulier métallique, est séparée du substrat semiconducteur par une couche isolante dont l'épaisseur peut être de l'ordre de quelques nanomètres. Un procédé typique de réalisation d'un tel élément conducteur est illustré aux figures 1 à 3. La formation de l'élément conducteur 1 est effectuée par dépôt d'une couche en matériau conducteur 3 sur une couche isolante 2, disposée sur un substrat 4, et délimitation par gravure de la couche en matériau conducteur 3 à travers un masque 5 en résine qui est ensuite enlevé. Le masque est formé sur une zone 6 de la couche conductrice 3 destinée à former l'élément conducteur 1, délimitant ainsi, dans la couche conductrice et la couche isolante, des zones complémentaires 7 non-recouvertes par le masque 5. Or, la gravure peut dégrader (par exemple déformer ou oxyder) les zones complémentaires 7 de la couche isolante 2 et le substrat 4, ce qui est d'autant plus difficile à éviter que l'épaisseur de la couche isolante 2 est faible. Certes, une gravure du matériau conducteur 3 sélective par rapport au matériau de la couche isolante 2 permet d'arrêter la gravure avant d'atteindre le substrat 4. Cependant une gravure sélective est difficile à obtenir. Par exemple, la gravure du nitrure de titane (TiN) est typiquement effectuée par des procédés à base d'hydrofluorocarbures (CH_{X}F_{Y}). Les mêmes procédés sont utilisés pour la gravure d'oxydes, en particulier de la silice (SiO₂). La sélectivité de la gravure d'une couche isolante par rapport au TiN est donc très faible et la dégradation de l'oxyde, voire un percement de la couche isolante et la dégradation du substrat sous-jacent, inévitable.

Dans certains procédés connus, le substrat 4 peut être oxydé ou déformé en fin de gravure à travers la couche isolante 2. Cette oxydation peut être désavantageuse, notamment dans le cas d'un substrat de type SOI (« silicon on insulator : SOI ») comportant une couche active très fine, dont la résistance est ainsi fortement augmentée.

Le document JP2002134544 décrit un procédé de délimitation d'une électrode métallique. Une couche métallique est formée sur une couche isolante disposée sur un substrat semiconducteur. Un masque en résine est formé sur une zone de la couche métallique. La couche métallique est transformée, par implantation d'ions d'oxygène, en couche d'oxyde isolant dans la région non-couverte par le masque en résine. Ainsi est formée une électrode métallique entourée par une couche d'oxyde.

Le document US6331490 (18 Dec 2001) décrit un procédé de retrait d'une couche mince d'une surface après l'élaboration d'un composant ou d'une interconnection. Le procédé comprend l'oxydation d'au moins une partie de la couche mince et la gravure de la couche mince oxydée en utilisant une solution qui grave en premier lieu la couche mince oxydée.

### Objet de l'invention

L'invention a pour but de remédier à ces inconvénients et, en particulier, de délimiter un élément conducteur disposé sur une couche isolante sans dégradation de la couche isolante et du substrat, afin de préserver les caractéristiques de résistance du dispositif.

Selon l'invention, ce but est atteint par les revendications annexées.

Selon une première variante de l'invention, la couche conductrice est constituée par des première et seconde couches conductrices, le procédé comportant une gravure de la seconde couche conductrice par l'intermédiaire du masque, l'oxydation étant effectuée après enlèvement du masque, de manière à ce que la surface de la seconde couche conductrice soit oxydée sur les parois latérales et sur la face avant et que les zones complémentaires de la première couche conductrice soient oxydées sur toute l'épaisseur de la première couche conductrice.

Selon une seconde variante de l'invention, le procédé comporte un recuit de stabilisation et d'évaporation, de manière à ce que le matériau de la couche conductrice et l'oxygène provenant de l'oxydation forment un oxyde volatil, la couche conductrice s'évaporant au moins en partie.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
Les figures 1 à 3 représentent un procédé selon l'art antérieur.
Les figures 4 à 6 représentent des étapes d'un mode de réalisation particulier d'un procédé selon l'invention, comportant la formation d'un oxyde volatil.
Les figures 7 à 10 représentent des étapes d'un autre mode de réalisation particulier d'un procédé selon l'invention, comportant la formation d'un oxyde volatil, utilisant des première et seconde couches conductrices.
Les figures 11 et 12 représentent des étapes d'un autre mode de réalisation particulier d'un procédé selon l'invention, comportant la formation d'un oxyde volatil, après enlèvement du masque.
Les figures 13 et 14 représentent des étapes d'un autre mode de réalisation particulier d'un procédé selon l'invention, comportant la formation d'un oxyde solide, après enlèvement du masque.

### Description de modes particuliers de réalisation

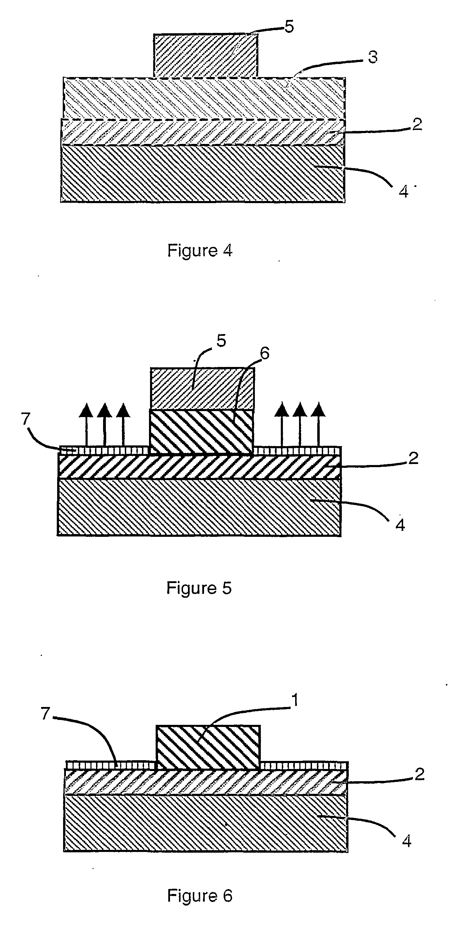

La figure 4 montre l'empilement d'un substrat 4 semiconducteur (par exemple Si, Ge, SiGe), d'une couche isolante 2 et d'une couche conductrice 3. Un masque 5 est disposé en face avant, sur la zone 6 de la couche conductrice 3, destinée à former l'élément conducteur, délimitant ainsi, dans la couche conductrice, les zones complémentaires 7, non-recouvertes par le masque 5. Le masque 5 peut être en résine ou constitué d'une bicouche (une couche de résine organique et une couche sacrificielle minérale, appelée « masque dur »). Dans le mode de réalisation particulier représenté aux figures 5 et 6, afin de délimiter un élément conducteur, les zones complémentaires 7 de la couche conductrice 3 sont rendues isolantes par une oxydation thermique. Comme représenté à la figure 5, pendant l'oxydation, le matériau de la couche conductrice 3 et l'oxygène forment un oxyde volatil, de manière à ce que les zones complémentaires 7 de la couche conductrice 3 s'évaporent en partie pendant l'oxydation. Les zones complémentaires 7 résiduelles de la couche conductrice 3 sont oxydées sur toute leur épaisseur, tandis que la zone 6 de la couche conductrice est protégée par le masque 5. Le matériau de la couche conductrice est choisi parmi les matériaux dont l'oxyde est isolant de sorte que les zones complémentaires 7 ne soient plus conductrices après oxydation. Ensuite, le masque 5 est enlevé (figure 6).

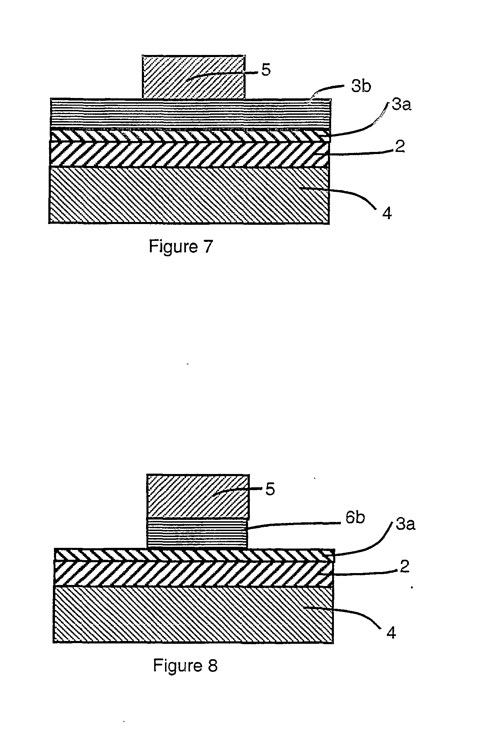

Sur la figure 7, la couche conductrice 3 est constitué par des première et seconde couches conductrices 3a et 3b superposées. Le masque 5 est formé au-dessus des couches 3a et 3b. La seconde couche conductrice 3b peut être gravée avant oxydation de la couche 3a. Comme représenté à la figure 8, lorsque les zones complémentaires 7 de la seconde couche conductrice 3b sont enlevées par la gravure, seule la zone 6b de la seconde couche conductrice 3b est conservée.

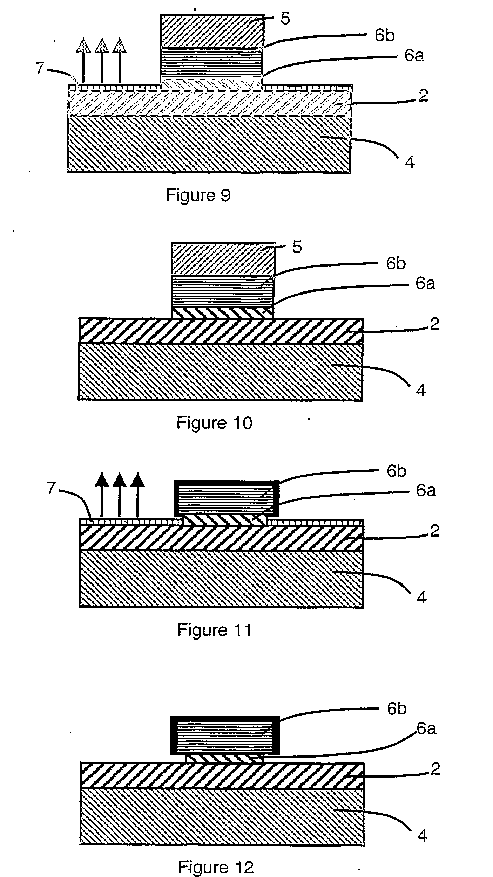

Dans une autre variante de réalisation, le procédé comporte un recuit de stabilisation et d'évaporation après une implantation d'oxygène utilisant des techniques du type implantation ionique ou plasma. L'implantation est, par exemple, effectuée par accélération d'ions oxygène ou par un procédé de gravure ionique réactive (« reactive ion etching : RIE »). La figure 9 illustre l'évaporation des zones complémentaires 7 oxydées de la première couche conductrice, la zone 6a de la première couche conductrice 3a étant protégée par le masque 5. Pendant le recuit, le matériau de la première couche conductrice 3a et l'oxygène implanté forment un .oxyde volatil et les zones complémentaires 7 oxydées de la couche conductrice 3a s'évaporent. L'élément conducteur 1 est alors formé par la superposition de la partie résiduelle (zone 6b) de la couche 3b et par la partie non-oxydée (zone 6a) de la couche 3a. Selon la durée du recuit ou la dose d'oxygène implanté, les zones complémentaires s'évaporent en partie (figure 9) ou en totalité (figure 10). L'enlèvement du masque 5 peut être effectué après le recuit si le masque est minéral. Dans le cas d'un masque en résine, il peut être enlevé avant.

Pour l'application du procédé, avec évaporation, le matériau de la première couche conductrice 3a est, de préférence, pris dans le groupe comprenant le tungstène, le molybdène, le nickel et le cobalt, et le matériau de la seconde couche conductrice 3b est du silicium polycristallin, un nitrure métallique ou un siliciure métallique comportant, par exemple, du tungstène, du tantale ou du molybdène (WSiₓ, MoSiₓ, TaSiₓ).

Par exemple, en utilisant une première couche conductrice 3a en tungstène, les atomes d'oxygène sont implantés dans le cristal de tungstène dans un état métastable, par exemple sur des sites interstitiels. Un oxyde de tungstène se forme ensuite pendant le recuit de stabilisation. L'oxyde de type WOₓ (x étant compris entre 1 et 3) est volatil et s'évapore. Typiquement ce phénomène peut être obtenu au-dessus de 200°C. Dans le cas de cette technique, la diffusion latérale d'oxygène est quasiment supprimée et l'oxydation périphérique de la zone 6a de la première couche conductrice 3a sous la zone 6b de la seconde couche conductrice 3b, représentée à la figure 11, est très faible.

Dans un autre développement du procédé avec évaporation, représenté aux figures 11 et 12, un oxyde volatil est formé par oxydation thermique à partir du matériau de la couche conductrice 3 et de l'oxygène. Sur la figure 11, la couche conductrice 3 est constituée par une première couche conductrice 3a et une seconde couche conductrice 3b gravée. Après enlèvement du masque 5 en résine, l'oxydation thermique peut être effectuée dans un four, par exemple à une température supérieure à 200°C pour le tungstène. Dans ce cas, un oxyde volatil du tungstène WO₃ se forme et s'évapore. Les figures 11 et 12 illustrent ce processus respectivement en cours d'évaporation et après évaporation complète. Ce processus favorise la diffusion des atomes d'oxygène dans le matériau conducteur et la périphérie de la zone 6a de la première couche conductrice 3a est oxydée sous la zone 6b de la seconde couche conductrice 3b. Ainsi, cette zone périphérique s'évapore également et on obtient un dispositif dont la zone 6b de la seconde couche conductrice 3b fait saillie à la périphérie de la zone 6a de la première couche conductrice 3a. La zone 6a de la première couche conductrice 3a est alors réduite. Afin de limiter la réduction de la zone 6a et une dégradation du substrat 4, l'oxydation thermique peut être arrêtée dès que la seconde couche conductrice s'est évaporée ou juste avant. Les zones complémentaires 7 rendues isolantes peuvent alors présenter, de préférence, une épaisseur au moins égale à une couche atomique. Comme représenté aux figures 11 et 12, le matériau de la seconde couche conductrice 3b est oxydé en surface sur les parois latérales et sur la face avant.

L'électrode de grille d'un transistor peut être réalisée par le procédé décrit ci-dessus. Dans ce cas, le substrat 4 est constitué par une couche active en matériau semiconducteur, par exemple en silicium homogène ou silicium sur isolant (SOI). Le procédé selon l'invention permet de délimiter l'électrode de grille en évitant une déformation des zones du substrat correspondant aux zones complémentaires 7 et en évitant la diffusion des espèces oxydantes dans la couche active ou dans la couche isolante entre l'électrode de grille et la couche active. La réalisation de l'électrode de grille par deux couches superposées 3a et 3b présente plusieurs avantages. Cela permet, notamment, de réduire les contraintes exercées par le matériau conducteur sur l'isolant, de masquer des implantations source et drain effectuées après la réalisation de l'électrode de grille, d'assurer un contact avec les interconnexions, d'éviter toute oxydation du matériau de grille postérieure à la réalisation de l'électrode de grille et de protéger le matériau de grille d'une métallisation (siliciuration) auto-alignée de la source et du drain.

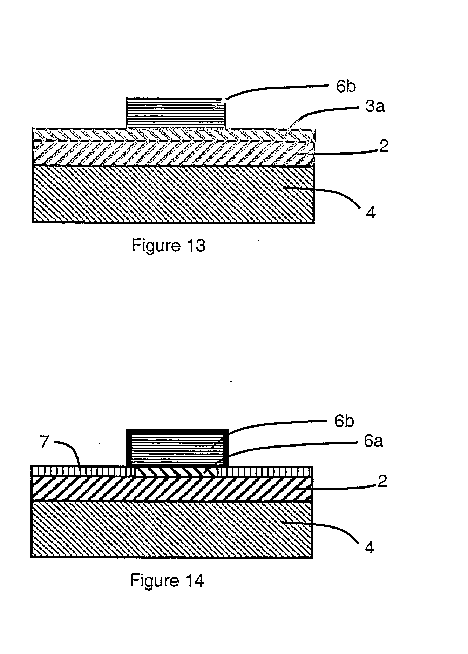

Dans une autre variante de l'invention, le masque 5 est enlevé (figure 13) après gravure de la seconde couche conductrice 3b (figure 8). Les zones complémentaires 7 de la première couche conductrice 3a sont ensuite oxydées par implantation d'oxygène, dans des conductions de température de pression appropriées, ou par oxydation thermique. Dans ce cas, représenté à la figure 14, le matériau de la seconde couche conductrice 3b est oxydé en surface à la fois sur ses parois latérales et sur sa face avant, tandis que les zones complémentaires 7 de la première couche conductrice 3a sont oxydées sur toute l'épaisseur de la première couche conductrice 3a. La diffusion des atomes dans les matériaux à haute température, notamment dans le cas d'une oxydation thermique, peut également conduire à une oxydation périphérique de la zone 6a de la première couche conductrice 3a sous la seconde couche conductrice 3b, comme représenté à la figure 14. La première couche conductrice 3a est, de préférence, en TiN et la seconde couche conductrice 3b en silicium polycristallin. Ainsi, un oxynitrure TiO_{X}N_{Y} se forme lors de l'oxydation.

Dans le cas d'une implantation d'oxygène, on ajoute, de préférence, une stabilisation thermique de l'état métastable de la couche comportant l'oxygène implanté par un recuit sous atmosphère inerte, par exemple une atmosphère d'argon. Dans ce cas, comme dans le cas d'une oxydation thermique, les zones complémentaires 7 de la couche conductrice 3 peuvent former un oxyde solide dans lequel les atomes d'oxygène et les atomes du matériau conducteur sont intégrés dans un seul réseau cristallin, les atomes d'oxygène se substituant, par exemple, aux atomes du matériau conducteur. Ainsi, l'élément conducteur 1 est formé par les parties non-isolantes, notamment non-oxydées, de la couche conductrice, tandis que les zones rendues isolantes forment une barrière latérale de l'élément conducteur.

L'invention n'est pas limitée aux modes de réalisation représentés, en particulier, l'oxydation peut être réalisée aussi bien thermiquement que par implantation d'oxygène, après enlèvement du masque. Par ailleurs, la formation d'un oxyde volatil, avant ou après enlèvement du masque, peut être réalisé par oxydation thermique ou par implantation d'oxygène, en utilisant une couche conductrice unique ou deux couches conductrices superposées.

## Revendications

1. Procédé de délimitation d'un élément conducteur (1) disposé sur une couche isolante (2), comportant le dépôt d'une couche conductrice (3) sur la face avant de la couche isolante (2) disposée sur un substrat (4), la formation d'un masque (5) sur au moins une zone (6) de la couche conductrice (3) destinée à former l'élément conducteur (1), de manière à délimiter dans la couche conductrice au moins une zone complémentaire (7) non-recouverte par le masque (5), les zones complémentaires (7) de la couche conductrice (3) étant rendues isolantes par oxydation, procédé **caractérisé en ce qu'**il comporte la formation, dans lesdites zones complémentaires (7) de la couche conductrice (3), d'un oxyde volatil à partir du matériau de la couche conductrice (3) et de l'oxygène provenant de l'oxydation, la couche conductrice (3) s'évaporant au moins en partie.

2. Procédé selon la revendication 1, **caractérisé en ce que** l'oxydation est effectuée avant enlèvement du masque (5).

3. Procédé selon l'une quelconque des revendications 1 à 2, **caractérisé en ce que** la formation de l'oxyde volatil et l'évaporation de la couche conductrice (3) ont lieu pendant l'oxydation.

4. Procédé selon l'une quelconque des revendications 1 à 2, **caractérisé en ce que** l'oxyde volatil est formé, après l'oxydation, par un recuit de stabilisation et d'évaporation.

5. Procédé selon l'une quelconque des revendications 1 à 4, **caractérisé en ce que** l'oxydation des zones complémentaires (7) de la couche conductrice (3) comporte une implantation d'oxygène.

6. Procédé selon l'une quelconque des revendications 1 à 4, **caractérisé en ce que** l'oxydation des zones complémentaires (7) de la couche conductrice (3) comporte une oxydation thermique.

7. Procédé selon l'une quelconque des revendications 1 à 6, **caractérisé en ce que** les zones complémentaires (7) rendues isolantes ont une épaisseur au moins égale à une couche atomique.

8. Procédé selon l'une quelconque des revendications 1 à 7, **caractérisé en ce que** le dépôt de la couche conductrice (3) comporte une première étape, de dépôt d'une première couche conductrice (3a), et une seconde étape, de dépôt d'une seconde couche conductrice (3b) sur la face avant de la première couche conductrice (3a).

9. Procédé selon la revendication 8, **caractérisé en ce qu'**il comporte, après la formation du masque (5) et avant l'oxydation, une gravure de la seconde couche conductrice (3b).

10. Procédé selon l'une des revendications 8 et 9, **caractérisé en ce que** le matériau de la première couche conductrice (3a) est pris dans le groupe comprenant le tungstène, le molybdène, le nickel et le cobalt, et le matériau de la seconde couche conductrice (3b) est du silicium polycristallin.

## Claims

1. Method for delineating a conducting element (1) disposed on an insulating layer (2), comprising deposition of a conducting layer (3) on the front face of the insulating layer (2) disposed on a substrate (4), formation of a mask (5) on at least one area (6) of the conducting layer (3) designed to form the conducting element (1), so as to delineate in the conducting layer at least one complementary area (7) not covered by the mask (5), the complementary areas (7) of the conducting layer (3) being rendered insulating by oxidation, method **characterized in that** it comprises forming, in said complementary areas (7) of the conducting layer (3), a volatile oxide made from the material of the conducting layer (3) and the oxygen arising from oxidation, the conducting layer (3) evaporating at least partly.

2. Method according to claim 1, **characterized in that** oxidation is performed before removing the mask (5).

3. Method according to any one of the claims 1 to 2, **characterized in that** formation of the volatile oxide and evaporation of the conducting layer (3) are performed during oxidation.

4. Method according to any one of the claims 1 to 2, **characterized in that** the volatile oxide is formed, after oxidation, by stabilizing and evaporating annealing.

5. Method according to any one of the claims 1 to 4, **characterized in that** oxidation of the complementary areas (7) of the conducting layer (3) comprises oxygen implantation.

6. Method according to any one of the claims 1 to 4, **characterized in that** oxidation of the complementary areas (7) of the conducting layer (3) comprises thermal oxidation.

7. Method according to any one of the claims 1 to 6, **characterized in that** the complementary areas (7) rendered insulating have a thickness at least equal to one atomic layer.

8. Method according to any one of the claims 1 to 7, **characterized in that** deposition of the conducting layer (3) comprises a first step of deposition of a first conducting layer (3a) and a second step of deposition of a second conducting layer (3b) on the front face of the first conducting layer (3a).

9. Method according to claim 8, **characterized in that** it comprises etching of the second conducting layer (3b) after formation of the mask (5) and before oxidation.

10. Method according to one of the claims 8 and 9, **characterized in that** the material of the first conducting layer (3a) is taken from the group comprising tungsten, molybdenum, nickel and cobalt, and the material of the second conducting layer (3b) is polycrystalline silicon.

## Patentansprüche

1. Verfahren zur Begrenzung eines auf einer isolierenden Schicht (2) angeordneten leitenden Elements (1), umfassend das Abscheiden einer leitenden Schicht (3) auf der Vorderseite der auf einem Substrat (4) angeordneten isolierenden Schicht (2), das Ausbilden einer Maske (5) auf wenigstens einem Bereich (6) der leitenden Schicht (3), welche dazu bestimmt ist, das leitende Element (1) zu bilden, um in der leitenden Schicht wenigstens einen ergänzenden Bereich (7), der nicht durch die Maske (5) bedeckt ist, zu begrenzen, wobei die ergänzenden Bereiche (7) der leitenden Schicht (3) durch Oxidation isolierend gemacht werden, Verfahren, welches **dadurch gekennzeichnet ist, dass** es die Bildung - in den ergänzenden Bereichen (7) der leitenden Schicht (3) - eines flüchtigen Oxids aus dem Material der leitenden Schicht (3) und aus dem aus der Oxidation stammenden Sauerstoff umfasst, wobei die leitende Schicht (3) wenigstens teilweise verdampft.

2. Verfahren nach Anspruch 1, **dadurch gekennzeichnet, dass** die Oxidation vor Entfernen der Maske (5) durchgeführt wird.

3. Verfahren nach einem der Ansprüche 1 bis 2, **dadurch gekennzeichnet, dass** die Bildung des flüchtigen Oxids und das Verdampfen der leitenden Schicht (3) während der Oxidation stattfinden.

4. Verfahren nach einem der Ansprüche 1 bis 2, **dadurch gekennzeichnet, dass** das flüchtige Oxid nach der Oxidation durch ein Stabilisations- und Verdampfungsglühen gebildet wird.

5. Verfahren nach einem der Ansprüche 1 bis 4, **dadurch gekennzeichnet, dass** die Oxidation der ergänzenden Bereiche (7) der leitenden Schicht (3) eine Implantation von Sauerstoff umfasst.

6. Verfahren nach einem der Ansprüche 1 bis 4, **dadurch gekennzeichnet, dass** die Oxidation der ergänzenden Bereiche (7) der leitenden Schicht (3) eine thermische Oxidation umfasst.

7. Verfahren nach einem der Ansprüche 1 bis 6, **dadurch gekennzeichnet, dass** die isolierend gemachten ergänzenden Bereiche (7) eine Dicke wenigstens gleich einer Atomschicht aufweisen.

8. Verfahren nach einem der Ansprüche 1 bis 7, **dadurch gekennzeichnet, dass** das Abscheiden der leitenden Schicht (3) einen ersten Schritt zum Abscheiden einer ersten leitenden Schicht (3a) und einen zweiten Schritt zum Abscheiden einer zweiten leitenden Schicht (3b) auf der Vorderseite der ersten leitenden Schicht (3a) umfasst.

9. Verfahren nach Anspruch 8, **dadurch gekennzeichnet, dass** es nach dem Ausbilden der Maske (5) und vor der Oxidation ein Ätzen der zweiten leitenden Schicht (3b) umfasst.

10. Verfahren nach einem der Ansprüche 8 und 9, **dadurch gekennzeichnet, dass** das Material der ersten leitenden Schicht (3a) aus der Gruppe umfassend Wolfram, Molybdän, Nickel und Kobalt ausgewählt ist und das Material der zweiten leitenden Schicht (3b) polykristallines Silizium ist.
